# EUROPEAN PATENT SPECIFICATION

(11) **EP 1 243 551 B1**
(45) Date of publication and mention of the grant of the patent: **26.05.2004**
(21) Application number: 02250896.4
(22) Date of filing: 08.02.2002
(51) Int. Cl.: C01B 5/00, B01J 12/00

(54) **Reactor for generating moisture**
Reaktor zur Herstellung von Feuchtigkeit
Réacteur pour la production d'humidité

(30) Priority: 23.03.2001 JP 2001084507
(43) Date of publication of application: 25.09.2002
(73) Proprietor: FUJIKIN INCORPORATED, Osaka (JP)
(72) Inventor: Komehana, Katsunori, Fujikin Incorporated, Osaka (JP); Minami, Yukio, Fujikin Incorporated, Osaka (JP); Kawada, Koji, Fujikin Incorporated, Osaka (JP); Morimoto, Akihiro Fujikin Incorporated, Osaka (JP); Ikeda, Nobukazu Fujikin Incorporated, Osaka (JP); Nakamura, Osamu, Fujikin Incorporated, Osaka (JP); Hon'Idenn, Teruo, Fujikin Incorporated, Osaka (JP); Hirai, Toru, Fujikin Incorporated, Osaka (JP)
(74) Representative: Crump, Julian Richard John

(56) References cited:
- EP-A- 0 987 217
- PATENT ABSTRACTS OF JAPAN vol. 2000, no. 09, 13 October 2000 (2000-10-13) & JP 2000 169110 A (FUJIKIN INC;OMI TADAHIRO), 20 June 2000 (2000-06-20)
- PATENT ABSTRACTS OF JAPAN vol. 2000, no. 06, 22 September 2000 (2000-09-22) & JP 2000 072405 A (OMI TADAHIRO;FUJIKIN INC), 7 March 2000 (2000-03-07)

## Description

### Field of the invention

The present invention relates to improvements in and relating to apparatus for generating moisture for use mainly in semiconductor manufacturing units. More specifically, the invention relates to a reactor for generating moisture that can minimize the quantity of unreacted gases in the generated moisture gas by forcibly mixing hydrogen and oxygen, thus increasing the reaction efficiency, and that can be used in a process in which a relatively small quantity of moisture is required.

### Background of the invention

The manufacture of semiconductors typically requires a wide range of flow rates of high purity moisture, from tens of sccm to thousands of sccm. The flow rate of moisture required differs according to the actual steps in any given manufacturing process. The unit "sccm" as used herein means cm³/min. in a standard state.

The inventors conducted intense research into the development of a reactor for generating moisture of a high flow rate type, producing no less than 1,000 sccm, and disclosed the reactor shown in FIG. 6 in unexamined Japanese patent application, published under No. 2000-169110, and the reactor shown in FIG. 7 in unexamined Japanese patent application JP 10297907.

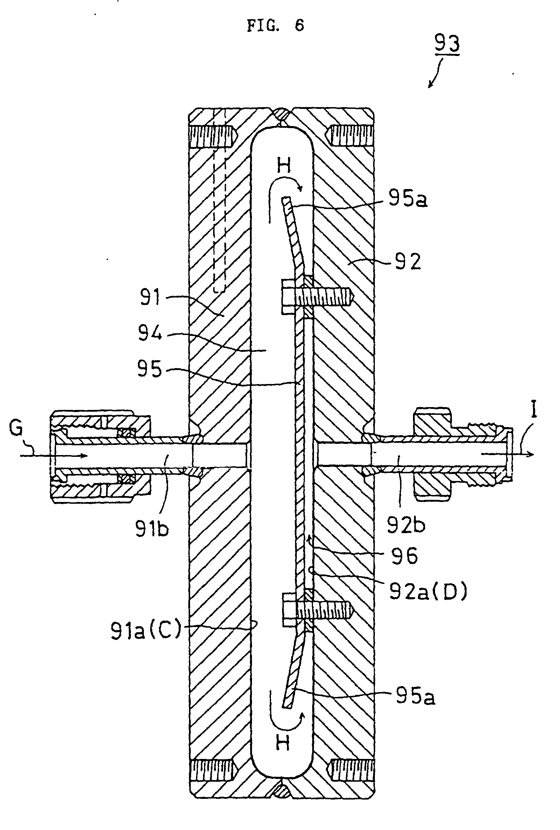

FIG. 6 is a vertical, sectional view of a first example of a high flow rate type reactor for generating moisture. In FIG. 6, the numeral 91 indicates a structural component on an inlet side; 91a, an inner wall of the structural component on the inlet side; 91b, a material gas feed port; 92, a reactor structural component on an outlet side; 92a, an inner wall of the reactor structural component on the outlet side; 92b, a moisture gas take-out port; 93, a reactor shell; 94, an interior space on the inlet side; 95, a reflector; 95a, the periphery of the reflector; 96, a micro-gap formed between the reflector 95 and the reactor structural component 92 on the outlet side.

A barrier coat C is formed on the inner wall 91a of the structural component on the inlet side, and a platinum coated catalyst layer D is formed on the inner wall 92a of the reactor structural component on the outlet side. Said platinum coated catalyst layer D is made by laminating a platinum coating film on a barrier film of TiN or the like, and the platinum coating film is exposed in the space 96.

Next, the operation of a high flow rate type reactor for generating moisture of the large flow rate type will be explained. Hydrogen gas and oxygen gas, provided at a specific ratio, are fed in the direction of the arrow G, and these starting material gases proceed from starting material gas feed port 91b into the interior space 94 on the inlet side. Then, the starting material gases flow in the direction of the arrow H, which forms a stream line, and reach the narrow gap 96 behind the reflector 95.

The temperature of the whole reactor is adjusted to 350 to 400°C by a heater (not shown) and is set to a temperature for promoting the moisture generating reaction. Under such conditions, the starting material hydrogen gas and oxygen gas come into contact with the platinum coated catalyst layer D formed on the inner wall 92a of the reactor structural component 92 on the outlet side and are radicalised. The radicalised hydrogen and oxygen are in a state of high reactivity and instantly combine with each other at a temperature lower than the ignition point to produce water vapour without combustion at a high temperature.

The higher the probability of the molecules colliding with each other, the more violent the reaction, and the moisture generating reaction proceeds rapidly in the narrow gap 96 or a space of minimal volume. A mixture I of the moisture gas and unreacted starting material gases is fed to the next process through the moisture gas take-out port 92b.

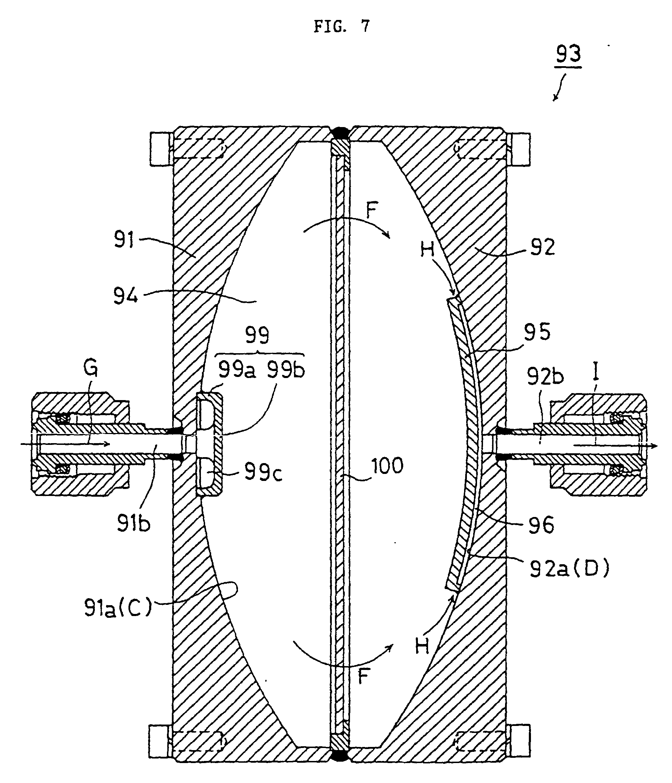

FIG. 7 is a vertical, sectional view of a second prior art example of a reactor for generating moisture of the high flow rate type. In this figure, the numerals 91 to 96, G, C, D, I are the same as in FIG. 6. Said reactor for generating moisture of the high flow rate type has a construction such that the reactor of fig. 7 comprises a reflector 99 on the inlet side and a filter 100. Reflector 99 on the inlet side is formed of casing 99a, reflector 99b on the inlet side and through-hole 99c. The starting material gases, which are jetted onto casing 99a, hit against the reflector 99b on the inlet side and diffuse, proceeding through through-hole 99c and spread throughout the interior space 94 on the inlet side.

The filter 100 is made in the form of a stainless steel net which allows fluid to pass through, and is effective in homogenizing the starting material gases diffusing in the interior space 94 on the inlet side and in stabilizing the gases at the same time. The starting material gases, homogenized and stabilized after passing through filter 100 (in the direction of the lower arrow), therefore proceed into the narrow gap 96 formed behind the reflector 95 and produce moisture gas through the radicalising reaction.

These two types of reactors for generating moisture are both of a high flow-rate type. A disk-like reflector 95 is provided in the interior space, and the starting material gases flow into a narrow gap 96 from the periphery 95a of the reflector. With the radius of reflector 95 as r, the starting material gases are allowed to enter the narrow gap 96 from the entire circumference, represented by 2πr, of the periphery 95a of the reflector. The starting material gases can thus be caused to flow at a high rate into the narrow gap 96, radicalised and then the moisture gas at a high flow rate is fed into a subsequent process.

As shown in FIG. 6 and FIG. 7, the starting material gases form a stream line moderately curved in the direction of the arrow H outside the periphery 95a of the reflector, and the starting material gases therefore proceed substantially in the form of a laminar flow into the narrow gap 96. Especially when the flow rate is low, the interaction between gas molecules is relatively weak, Reynold's number reduces, and the flow tends to be in the form of laminar flow.

If the starting material gases are in a state of laminar flow, then the probability of hydrogen and oxygen gas molecule colliding is decreased, and it is thought that the probability of moisture generation will be lower than in the case of turbulent flow. This means that a high concentration of unreacted starting material gases remain in the product moisture gas. There is a risk that if flammable hydrogen gas remains in relatively high concentration, the gas will explode in the subsequent process. The quantity of unreacted gas is therefore constantly monitored, and. if the concentration of unreacted gases exceeds a predetermined level, emergency measures, such as suspension of supply of the starting material gases, are taken.

For this reason, the inventors have taken various measures to improve the reaction rate in the prior art reactor. For example, the inventors have improved the platinum coated catalyst layer, made the interior temperature even and uniform throughout the whole reactor and adjusted the ratio between hydrogen gas and oxygen gas in the starting material gases. However, such measures had only a limited effect in improving the reaction ratio. Furthermore, the prior art reactors are reactors for generating moisture at a high flow rate, and the whole volume of the reactor is large. It is some time before moisture gas can be generated and hence the reactor cannot respond promptly when moisture is needed immediately. Another problem is that when moisture gas is no longer needed, it is difficult to replace quickly the moisture gas with inert gas.

The inventors have come up with a quite different idea to improve the efficiency of the moisture generation reaction. The idea is to stir forcibly the starting material gases into a turbulent state in the reactor. Stirring the starting material gases into a turbulent state would sharply increase the collision probability of hydrogen gas and oxygen gas, and, as a result, moisture generation will be more efficient. If the forced turbulence method were to be adopted in a reactor for generating moisture of a low flow rate type that tends to produce laminar flow, then the moisture generation ratio should especially improve.

### Summary of the invention

Accordingly, it is an object of the present invention to provide a reactor for generating moisture, especially suitable for a low flow rate, by developing a structure which forces the starting material gases into turbulent flow in the reactor so that a high efficiency of the reaction for generating moisture is achieved, and the quantity of unreacted gas remaining in moisture gas is minimised.

The invention as claimed in claim 1 is a reactor for generating moisture which comprises a reactor structural component on an inlet side which supplies starting material gases to an interior space on said inlet side from a starting material gas feed port, a reactor structural component on an outlet side which transfers generated moisture gas to a moisture gas take-out port from a moisture gas feed passage, a reflector tightly clamped air-tight is between the reactor structural component on the inlet side and the reactor structural component on the outlet side and which has a plurality of blowing holes at predetermined locations for communicating with said interior space on the inlet side, a reactor chamber formed with a narrow gap provided between the reflector and the reactor structural component on the outlet side, a nozzle hole formed in the reactor structural component on the outlet side so that said reactor chamber communicates with the moisture gas feed passage in the reactor structural component on the outlet side and a coating catalyst layer formed on a wall surface of the reaction chamber facing the reflector, wherein when hydrogen and oxygen fed from the starting material gas feed port flow into the reactor chamber through the blowing holes in the reflector, hydrogen and oxygen react and generate moisture gas through a non-combustive pathway by the catalytic effect of said coating catalyst layer.

The invention as claimed in claim 2 is the reactor for generating moisture as claimed in claim 1 wherein a flange on an inlet side is formed on the end face of the reactor structural component on the inlet side, and a flange on the outlet side is formed on an end face of the reactor structural component on the outlet side, with the periphery of the reflector tightly clamped between the flange on the inlet side and the flange on the outlet side.

The invention as claimed in claim 3 is the reactor for generating moisture according to claim 1, wherein the reactor structural component on the inlet side and the reactor structural component on the outlet side are made of a reactor structural tube on the inlet side and a reactor structural tube on the outlet side, and the reflector is made of a reflection plate.

The invention as claimed in claim 4 is the reactor for generating moisture as claimed in claim 1 wherein the coating catalyst layer is formed on a surface of the reflector facing the reaction chamber and/or the surface of the nozzle hole.

The invention as claimed in claim 5 is the reactor for generating moisture as claimed in claim 1 wherein the coating catalyst layer comprises a coating film laminated and fixed on a barrier film.

The invention as claimed in claim 6 is the reactor for generating moisture as claimed in claim 5 wherein said coating film is made of platinum, and said barrier film is formed of any one of TiN, TiC, TiCN, TiAIN, Al₂O₃, Cr₂O₃, SiO₂, and CrN.

The invention as claimed in claim 7 is a reactor for generating moisture as claimed in claim 2 or claim 3 wherein the periphery of the reflector is tightly clamped between the flange on the inlet side and the flange on the outlet side by a screw engaging a nut or coupling provided on an outer circumferential surface of the reactor structural component on the inlet side, with a coupling or nut provided on the outer circumferential surface of the reactor structural component on the outlet side.

The invention as claimed in claim 8 is a reactor for generating moisture as claimed in claim 7, with a bearing placed between the nut and a back-side of the flange on which the nut is provided to facilitate turning of the coupling and the screwed nut.

### Brief description of the drawings

FIG. 1 is a sectional view of a low flow rate type reactor for generating moisture of an embodiment according to the present invention.
FIG. 2 is a perspective view of a reflector used in the embodiment according to the present invention.
FIG. 3 is a sectional view of an essential part of the embodiment according to the present invention.
FIG. 4 is a sectional view of a diaphragm type gas concentration detector connected to a low flow rate type reactor for generating moisture.
FIG. 5 is a sectional view of a diaphragm detector.
FIG. 6 is a vertical, sectional view of a first prior art example of an high flow rate type reactor for generating moisture.
FIG. 7 is a vertical, section view of a second prior art example of an high flow rate type reactor generating moisture.

### Description of the preferred embodiments

Now, an embodiment of a low flow rate type reactor for generating moisture according to the present invention will be described with reference to the drawings.

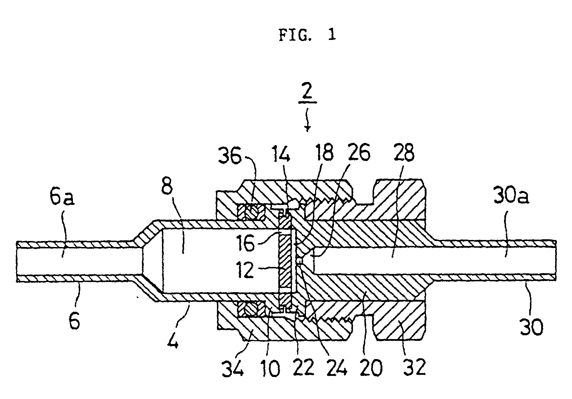

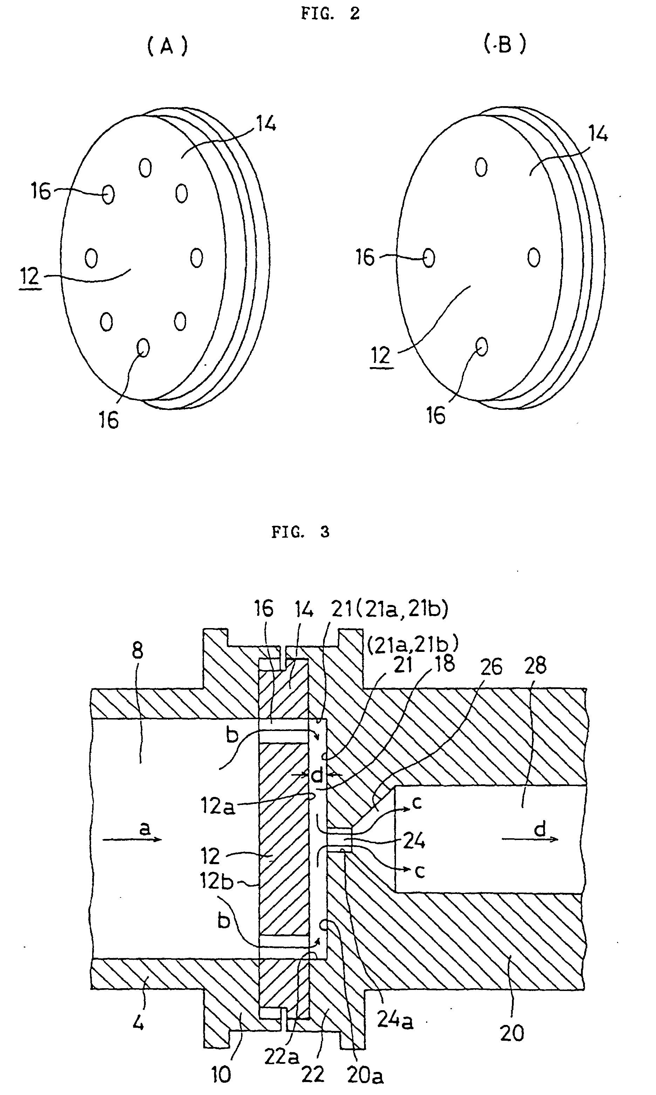

FIGS. 1, 2 and 3 show a reactor for generating moisture according to the present invention. FIG. 1 is a sectional view of the reactor for generating moisture. FIG. 2 is a perspective view of the reflector while FIG. 3 is a sectional view of the essential part explaining the operation.

In FIGS. 1 to 3, the numeral 2 indicates a reactor for moisture generation; 4 is a reactor structural component on an inlet side; 6, a starting material gas feed pipe; 6a, a starting material gas feed port; 8, an interior space on the inlet side; 10, a flange on the inlet side; 12, a reflector; 12a, a inner end face of the reflector; 12b, an outer end face of the reflector; 14, a periphery; 16, a blowing hole; 18, a reaction chamber; 20, a reactor structural component on the outlet side; 20a, an end surface of the reactor structural component on the outlet side; 21, a coating catalyst layer; 21a, a barrier film; 21b, a coating film; 22, a flange on the outlet side; 22a, a flange inner circumferential surface on the outlet side; 24, a nozzle hole; 26, a diffusion section; 28, a moisture gas feed passage; 30, a moisture gas take-out pipe; 30a, a moisture gas take-out port; 32, a coupling; 34, a nut; and 36, a bearing.

There will now be explained in detail the inter-relation of the above mentioned parts. A large diameter reactor structural component 4 on an inlet side, having an inlet side flange 10 at one end, is connected to a small diameter starting material gas feed pipe 6, and a mixture of hydrogen gas and oxygen gas at a predetermined ratio is fed from starting material gas feed port 6a.

A flange 22 on an outlet side is formed on the periphery of an end surface 20a of a large diameter reactor structural component 20 on the outlet side. A nozzle hole 24 is formed in the centre of the end surface 20a of the reactor structural component 20 on the outlet side. Said nozzle hole 24 is connected to moisture gas feed passage 28 via a diffusion section 26 of frustoconical shape which flares outwardly towards the passage 28. Furthermore, said moisture gas feed passage 28 is connected to a moisture gas take-out port 30a of a moisture gas take-out pipe 30, so that the generated moisture gas can be supplied to a process downstream.

A reflector 12 is provided between the flange 10 on the inlet side and the flange 22 on the outlet side, and its periphery 14 is held and clamped between the two flanges 10, 22. Clamping the reflector 12 between flanges 10, 22 seals the circumferential region of the reflector 12 and keeps that region air-tight. The reflector 12 is disk-shaped, and a plurality of small blowing holes 16 are bored on the inner side of the periphery 14 at specific intervals circumferentially. The blowing holes 16 communicate with the interior space 8 on the inlet side.

The positions of the blowing holes 16 are not limited to circumferential positions. What is important is merely that gases jetted into the blowing holes 16 undergo a moisture generation reaction before the gases reach the nozzle hole 24. The blowing holes 16 may thus be zigzagged in the circumferential direction or arranged in the radial direction. Increasing the length of the passage between the blowing holes 16 and the nozzle hole 24 effectively increases the chances of the reaction occurring. In this embodiment, therefore, the blowing holes 16 are provided at positions close to the circumference. A coupling 32 is fitted around an outer circumferential surface of the reactor structure component 20, on the outlet side, such that said coupling 32 comes into contact with the flange 22 on the outlet side. Furthermore, a bearing 26 is fitted to the outer circumferential surface of the reactor structural component 4 on the inlet side, such that the bearing 36 comes into contact with said flange 10 on the inlet side. Said outer surface also carries a nut 34. Said nut 34 and said coupling 32 are screwed to each other to provide a reactor for moisture generation 2 of the low flow rate type which is firmly assembled as a single unit.

As described earlier, the reflector 12 and said, two flanges 10, 22 are firmly united by mating said nut 34 and said coupling 32, thus guaranteeing the durability of the reactor for moisture generation 2 of the present invention. Furthermore, if the reactor structural component 4 on the inlet side and the reactor structural component 20 on the outlet side are made of pipe, then the reactor structural pipe on the inlet side and the reactor structural pipe on the outlet side can be assembled to form the reactor for moisture generation 2 by merely turning and tightening said nut 34 and said coupling 32.

In FIG. 1, the nut 34 is provided on the outer circumferential surface of the reactor structural component 4 on the inlet side, and coupling 32 is disposed around the outer circumferential surface of the reactor structural component 20 on the outlet side. Nut 34 and coupling 32 may be interchanged, with the coupling 32 being provided on the outer circumferential surface of the reactor structural component 4 on the inlet side and the nut 34 being disposed on the outer circumferential surface of the reactor structural component 20 on the outlet side.

Next, will be explained the essential of the structure reaction chamber 18. Referring to FIG. 3, an inner end face 12a of the reflector 12 and the end surface 20a of the reactor structural component on the outlet side of the reactor structural component 20 on the outlet side are spaced by narrow gap d, and oppose one another, forming said reaction chamber 18. That is, the periphery of the inlet side of the reaction chamber 18 communicates with the inlet side of the interior space 8 via the plurality of blowing holes 16, and a central region of the outlet side of reaction chamber 18 communicates with the moisture gas feed passage 28 through the nozzle hole 24.

In the present embodiment, the reflector 12 shown in FIG. 2 (A) is used. This reflector 12 is provided with eight circumferentially equispaced blowing holes 16. The reflector 12 shown in FIG. 2(B) is another example in which four circumferentially equispaced blowing holes 16 are formed. As illustrated, the actual number of holes 16 can be selected.

Since the peripheral region of the reflector 12 is held air-tightly between the two flanges, it is difficult to supply the starting material gases in large quantities. The only feed ports are the blowing holes 16, and the feed quantity can be adjusted by selecting the number of blowing holes 16 and the hole diameter. The smaller the number of blowing holes 16, the lesser the feeding quantity of starting material gases, thus reducing the flow rate. The larger the number of blowing holes 16, the greater the feeding quantity of starting material gases, thereby increasing the flow rate.

The diameter of the blowing hole 16 and the nozzle hole 24 can be freely adjusted. To achieve precise control over the low flow rate of the moisture gas, the diameter should be 0.1 mm to 3 mm, preferably 0.5 mm to 2 mm. If the diameter is set within this range, it is easy to mix the starting material gases uniformly.

The reactor for moisture generation 2 according to the present embodiment is made of stainless steel, which has excellent durability, corrosion resistance and heat resistance. Specifically, the reactor structural component 4 on the inlet side, the reactor structural component 20 on the outlet side, the reflector 12, the coupling 32 and the nut 34 are made of stainless steel JIS designation SUS316L.

A coating catalyst layer 21 is formed on a face of the end surface 20a of the reactor structural component 20 on the outlet side. Also, an inner circumferential surface 22a of the flange 22 on the outlet side is coated with a coating catalyst layer 21. Furthermore, the inner end face 12a of the reflector 12 and the surface of the nozzle hole 24 may be coated with a coating catalyst layer 21 depending on the circumstances. However, the coating catalyst layer 21 on the inner end face 12a of the reflector and on the surface of nozzle hole 24 are not always necessary. As described, the coating catalyst layer 21 is formed on the walls of the reaction chamber 18 to increase the water-generating capacity of the reaction chamber 18.

Said coating catalyst layers 21 are formed as follows. After a barrier film 21a is formed on the stainless steel, a coating film 21b is formed on the barrier film 21a. Said coating film 21b is formed as the top layer in order to activate the starting material gases. The barrier film 21a protects the underlying stainless steel materials from oxidation by the flowing gas and stops diffusion of the oxidizing agents, and resists the peeling of the coating film 21b.

The coating film 21b has a catalytic action in enhancing the reaction of the starting material gases to generate moisture gas. The noble metals (Ir, Ru, Rh, Pd, Ag, Pt, Au) are heat-resistant catalytic metals. Among them, platinum (Pt) as a catalytic metal has excellent in heat resistance, stability and efficiency. A platinum coating film is therefore often used as the coating film 21b. When a platinum coating film is used, the coating catalyst layer 21 is called a platinum coating catalytic layer. However, besides platinum, one or a combination of the other above-mentioned noble metals can be used. The thickness of the coating film 21b is preferably 0.1 µm to 3 µm. In the present embodiment, a coating film 21b with a thickness of about 1 µm is used. The thickness of barrier film 21a is preferably 0.1 µm to 5 µm. In the present embodiment, a barrier film 21a of TiN with a thickness of about 2 µm is used.

In forming the barrier film 21a, specific surface areas such as the reactor structural component 4 on the inlet side, reactor structural component 20 on the outlet side and reflector 12 are surface treated to remove any oxide or passive state film naturally formed of various metals on the stainless steel surface. Then, the barrier film 21a of TiN is formed. In the present embodiment, a TiN barrier film 21a about 2 µm is formed by an ion plating process.

Besides TiN, many other materials such as other nitrides, carbides and oxides can be used in forming the barrier film. The examples include TiC, TiCN, TiAIN, Al₂O₃, Cr₂O₃, SiO₂, and CrN. These are non catalytic and are highly resistant to oxidation and reduction. The thickness of the barrier film is preferably 0.1 µm to 5 µm as mentioned above. If the thickness is not greater than 0.1 µm, then the barrier is not sufficiently effective. If the thickness exceeds 5 µm, then it takes a long time to form the barrier film. Furthermore, there a risk that the barrier film will peel when heated owing to a difference in expansion coefficients.

In addition to the above-mentioned ion plating method, there are other methods such as PVD process-like ion spattering and vacuum vapour deposition, chemical vapour deposition (CVD method), hot pressing, and flame coating.

When formation of the barrier film 21a is complete, the coating film 21b is formed thereon. In the present embodiment, a coating film 21b about 1 µm thick is formed by an ion plating method. The coating thickness is preferably 0.1 µm to 3 µm. If the thickness is not greater than 0.1 µm, then the catalytic activity of the film may not last very long. If the thickness is greater than 3 µm, then the cost of the coating film will be too great. Furthermore, a thickness of greater than 3 µm would make little difference in catalytic activity and retention period. Furthermore, there is a risk of the film peeling when heated owing to a difference in expansion coefficients.

The coating film 21b can be formed by an ion plating method, and also by such methods as ion sputtering, vacuum vapour deposition, chemical vapour deposition and hot pressing. In addition, if the barrier film 21a is formed of an electric conductive material like TiN, then it is possible to use the electrolytic plating. However, the electrode-less plating methods can be used irrespective of the electrical conductivity of the barrier film 21a.

Next, there will be explained the mechanism of generating moisture with reference to FIG. 3. The starting material gases or a mixture of hydrogen gas and oxygen gas at a predetermined ratio is fed from the starting material gas feed port 6a. The starting material gases flow (in the direction of the arrow a) into the interior space 8 on the inlet side and impinge on an outer end face 12b of the reflector 12. Upon hitting said outer end face, the starting material gases diffuse and flow in the direction of the arrow b into the reaction chamber 18 through the blowing holes 16. Flowing into the reaction chamber 18, the starting material gases violently collide against the end surface 20a and are stirred forcibly into a turbulent state in reaction chamber 18. As a result of multiple reflections within the reaction chamber 18, the turbulent motion is further enhanced, whereby the starting material gases are well mixed.

Since the wall surfaces (end surface 20a, inner circumferential surface 22a) of reaction chamber 18 comprise the coating catalyst layers 21, the mixed gases in a turbulent state violently contact the coating catalyst layer 21 several times. As a result, hydrogen and oxygen molecules are rapidly radicalised into an activated state. Further, the radicalised hydrogen and oxygen radicals repeatedly hit against each other in a turbulent state and associate upon collision to form water molecules.

A principle aspect of the present invention consists in forcing the starting material gases into a turbulent state in the reaction chamber 18, thereby increasing the efficiency and speed of the radical reaction between hydrogen and oxygen and the generation of moisture. To enhance this turbulent state, the reaction chamber 18 is provided with a narrow gap d. Said narrow gap d has a width of 0.1 mm to 5 mm, preferably 0.5 mm to 3 mm. The width of the gap depends on the quantity of moisture required.

As described, if the moisture gas formation rate in the reaction chamber 18 increase then, the concentration of starting material gases remaining unreacted in the moisture gas is minimized. That is, the amounts of hydrogen gas and oxygen gas that are discharged unreacted are minimized, and that greatly improves the safety of moisture gas to be sent to a downstream process. In addition, even if the amounts of unreacted gases are constantly monitored for safety, if the amounts of unreacted gas are minimized, then there is no possibility that the supply of starting material gases need be suspended.

Generated moisture gas and an extremely small quantity of unreacted starting material gases diffuse and flow in the direction of the arrow c through a diffusion section 26. The gas is then sent to a subsequent process via the moisture gas take-out pipe 30.

The coating catalyst layer 21 may be formed on the inner end face 12a of the reflector 12 to enhance the radicalising and moisture generation reactions in the reaction chamber 18. Also, the inner surface of the nozzle hole 24, where the gas flow path is narrowed may be provided with a coating catalyst layer 21.

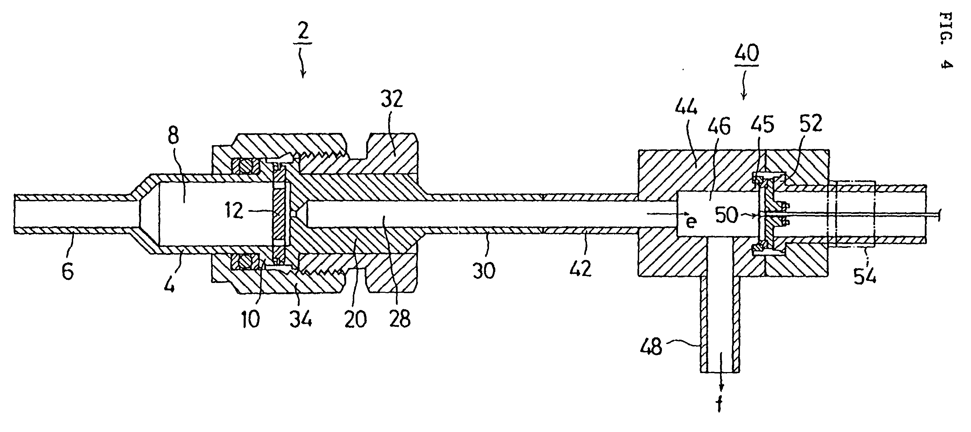

FIG. 4 is a sectional view of a gas concentration detector 40 of the diaphragm type which is connected to a reactor for generating moisture of the low flow rate type. Ideally 100% of the starting material gases are reacted to generate moisture gas, with no remaining unreacted gases. However, in reality, unreacted gases are always contained in the gases that are discharged. Especially if hydrogen gas remains, there is danger of the gas exploding in a subsequent process. For this reason, the gas concentration detector 40 is used to detect hydrogen gas. Said gas concentration detector 40 is designed so that if it is found that the concentration of residual hydrogen gas reaches a specific level, emergency measures such as suspension of the supply of starting material gases will be taken.

Said gas concentration detector 40 comprises a moisture gas inlet pipe 42, a sensor body 44 comprising a measurement space 46, a supporter 45 and a tightening flange body 52 to clamp tightly the diaphragm detector 50, a tightening bolt 54 and a moisture gas lead pipe 48.

Generated moisture gas flows from the moisture gas inlet pipe 42 into the measurement space 46 in the direction of arrow e. After the residual hydrogen concentration has been detected by the diaphragm detector 50, the gas is supplied to the a subsequent process in the direction of arrow f, through the moisture gas lead pipe 48.

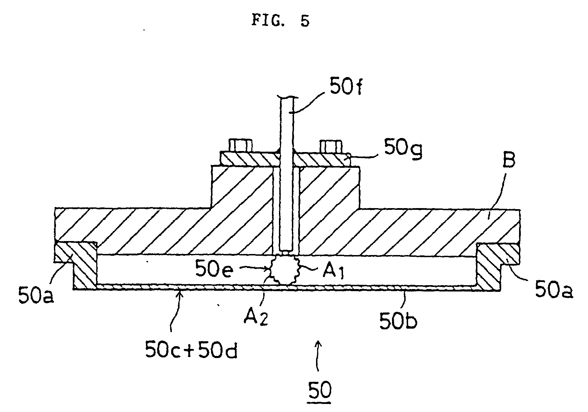

FIG. 5 is a sectional view of the diaphragm detector 50. A thin plate-formed diaphragm 50b surrounded by a diaphragm base 50a is provided and said diaphragm base 50a is fixed to a thermocouple supporter B. In the centre of thermocouple supporter B, a through-hole is made. In this through hole, a sheath body 50f in which a thermocouple 50e is mounted is inserted. Said sheath body 50f is fixed to the thermocouple supporter B by means of a collar body 50g.

The thermocouple 50e is made of two kinds of thermocouple metal A1, A2. Among such metals are chromel-alumel, copper-constantan, iron-constantan. One contact point of said thermocouple metals for A1, A2 is fused and spot-welded onto the reverse side of the diaphragm 50b, and another contact point arranged so as to measure the room temperature. In detecting temperature, compensation is made for room temperature.

A coating catalytic layer is formed on the surface of the diaphragm 50b that contacts the moisture gas, which coating catalyst layer comprises a base, or underlying barrier film 50c and an exposed coating film 50d. If moisture gas impinges on the coating catalytic layer, then small quantities of hydrogen gas and oxygen gas in the moisture gas are radicalised causing a moisture generating reaction. If moisture is generated, then the diaphragm 50b is heated by heat generated by the reaction and temperature rises. This temperature rise is detected by the thermocouple 50e as a measure of the concentration of unreacted gases in moisture gas.

If the concentration of hydrogen gas remaining in moisture gas is found to be higher than a predetermined level, an alarm is sounded, and the supply of starting material gases is suspended. If a correction is made to bring down the concentration of unreacted gas to below the predetermined level, then the moisture generation reaction is re-started and generated gas is supplied to the subsequent process.

The present invention can exhibit the aforesaid effects well if it is applied to reactor for generating moisture of the low flow rate type. However, if the number of blowing holes 16 is increased, then the reactor for generating moisture can be of a high flow rate type. In that case, too, the gas turbulence and mixing are effected sufficiently, and the efficiency of moisture generation can be improved.

According to the invention as claimed in claim 1, starting material gases are blown into a small gap reaction chamber 18 through a plurality of blowing holes 16 provided at predetermined locations on reflector 12, and therefore the starting material gases are in a turbulent state and evenly mixed, which accelerates the formation of radicals at the coating catalyst layer 21 and enhances the moisture generation reaction at the same time. As a result, even if starting material gases are supplied at a low flow rate, moisture can be generated with a high efficiency, whereby residual unreacted gases can be reduced to a minimum. The same results can be obtained with the high flow rate.

According to the invention as claimed in claim 2, the periphery of the reflector 12 is tightly clamped between the flange 10 on the inlet side and the flange 22 on the outlet side, and therefore reactor structural component 4 on the inlet side and the reactor structural component 20 on the outlet side can be assembled securely and air-tightly, and thus the durability of the whole reactor can be improved.

According to the invention of claim 3, the reactor comprises a reactor structural tube on the inlet side and a reactor structural tube on the outlet side such that clamping of the reflector 12 and assembly of the reactor can be achieved by engaging and tightening the coupling 32 and the nut 34 alone.

According to the invention as claimed in claim 4, the coating catalyst layer 21 is formed on an inner end face 12a of the reflector 12, facing the reaction chamber, and/or the surface of nozzle hole 24, and the radicalising reaction and moisture generation reaction can therefore be carried out with high efficiency, and the concentrations of residual unreacted gases can be reduced to a minimum.

According to the invention as claimed in claim 5, coating catalyst layer 21 is formed by laminating and fixing a coating film 21b onto a barrier film 21a, and there is therefore no possibility of the coating film 21b peeling off . The barrier film 21a also protects the underlying metal from oxidation and there is no diffusion of the base metal into the platinum. Thus, a durable reactor for generating moisture is provided.

According to the invention as claimed in claim 6, the barrier film 21a comprises any one of TiN, TiC, TiCN, TiAIN, Al₂O₃, Cr₂O₃, SiO₂, CrN. These materials improve durability of coating film 21b, and prevent the base metal oxidizing and diffusing. Hence, a reactor for generating moisture with a long-life can be provided.

According to the inventions as claimed in claim 7 and claim 8, the reactor for generating moisture can be assembled by screwing nut 34 and coupling 32 alone, which makes it possible to reduce the costs of manufacturing the reactor for generating moisture.

## Claims

1. A reactor (2) for generating moisture comprising:
a first inlet-side reactor structural component (4) and a second outlet-side reactor structural component (20), which first and second structural components (4,20) are adapted to be assembled to define an interior space;
a starting material gas feed port (6a) in said first structural component, which gas feed port is adapted to supply starting material gases to an inlet side (8) of said interior space;
a moisture gas feed passage (28) in said second structural component, adapted to remove generated gas to a moisture gas take-out port (30a); a reflector (12) clamped air-tightly between the first and second reactor structural components (4,20), which reflector defines a plurality of blowing holes (16) at predetermined locations in communication with said inlet-side (8) interior space;
a reactor chamber (18) comprising a narrow gap intermediate said reflector (12) and said second reactor structural component (20);
a nozzle hole (24) formed in the second reactor structural component (20) such that said reactor chamber communicates with said moisture gas feed passage (28) in the second reactor structural component;
and a coating catalyst layer (21) formed on a wall surface of said reactor chamber facing the reflector, wherein when hydrogen and oxygen fed from the starting material gas feed port flow into the reaction chamber through the blowing holes in the reactor, hydrogen and oxygen react and generate moisture gas in a non-combustion state through catalytic effect of the coating catalyst layer.

2. A reactor for generating moisture as claimed in claim 1, wherein a first inlet-side flange (10) is formed on an end of the first structural component (4), and a second outlet-side flange (22) is formed on an end the second structural component (20), and the periphery of the reflector (12) is tightly clamped between the first and second flanges (10,22).

3. A reactor for generating moisture as claimed in claim 1 or claim 2, wherein the first structural component (4) and the second structural component (20) each comprise a structural tube, and said reflector (12) comprises a reflection plate.

4. A reactor for generating moisture as claimed in claim 1, claim 2 or claim 3, wherein a coating catalyst layer (21) is formed on a surface of the reflector (12) facing said reaction chamber (18) and/or an interior surface of the nozzle hole (24).

5. A reactor for generating moisture as claimed in any preceding claim, wherein said coating catalyst layer (21) comprises a coating film (21b) laminated and fixed onto a barrier film (21a).

6. A reactor for generating moisture as claimed in claim 5, wherein said coating film (21b) comprises platinum, and said barrier film (21a) comprises of any one of TiN, TiC, TiCN, TiAIN, Al₂O₃, Cr₂O₃, SiO₂, CrN.

7. A reactor for generating moisture as claimed in claim 2 or claim 3, wherein the periphery of the reflector (12) is tightly clamped between the first and second flanges (10,22) by means of a screw-threaded nut member (34) provided on the outer circumferential surface of one of the first and second structural components (4,20) and a correspondingly screw-threaded coupling member (32) provided on the outer circumferential surface of the other structural component (20,4), wherein said nut member is adapted to engage said coupling member.

8. A reactor for generating moisture as claimed in claim 7, wherein a bearing (36) is interposed between said nut member (34) and a reverse side of the flange (10,22) on which said nut is provided, thereby to facilitate turning of the coupling (32) and the nut (34).

## Patentansprüche

1. Reaktor (2) zum Erzeugen von Feuchtigkeit, umfassend:
ein erstes einlassseitiges Reaktorstrukturelement (4) und ein zweites auslassseitiges Reaktorstrukturelement (20), wobei das erste und zweite Strukturelement (4, 20) dazu geeignet sind, zusammengebaut zu werden, um einen Innenraum zu definieren;
einen Ausgangsmaterialgaszufuhrdurchlass (6a) in dem ersten Strukturelement, wobei der Gaszufuhrdurchlass dazu geeignet ist, Ausgangsmaterialgase einer Einlassseite (8) des Innenraums zuzuführen;
einen Feuchtigkeitsgaszufuhrdurchgang (28) in dem zweiten Strukturelement, der dazu geeignet ist, erzeugtes Gas zu einem Feuchtigkeitsgasentnahmedurchlass 30a abzuleiten;
einen Reflektor (12), der luftdicht zwischen das erste und zweite Reaktorstrukturelement (4, 20) geklemmt ist, wobei der Reflektor eine Vielzahl von Blasöffnungen (16) an vorbestimmten Stellen definiert, die mit dem Innenraum an der Einlassseite (8) in Verbindung stehen;
eine Reaktorkammer (18), die einen schmalen Spalt zwischen dem Reflektor (12) und dem zweiten Reaktorstrukturelement (20) umfasst;
eine Düsenöffnung (24), die in dem zweiten Reaktorstrukturelement (20) derart ausgebildet ist, dass die Reaktorkammmer mit dem Feuchtigkeitsgaszufuhrdurchgang (28) in dem zweiten Reaktorstrukturelement in Verbindung steht;
und eine Katalysatorschicht (21), die auf einer dem Reflektor zugewandten Wandoberfläche der Reaktorkammer gebildet ist, wobei, wenn von dem Ausgangsmaterialgaszufuhrdurchlass zugeführter Wasserstoff und Sauerstoff durch die Blasöffnungen in dem Reaktor in die Reaktionskammer strömen, Wasserstoff und Sauerstoff reagieren und durch den katalytischen Effekt der Katalysatorschicht Feuchtigkeitsgas in einem Nichtverbrennungszustand erzeugen.

2. Reaktor zum Erzeugen von Feuchtigkeit nach Anspruch 1, wobei ein erster einlassseitiger Flansch (10) an einem Ende des ersten Strukturelements (4) gebildet ist, und ein zweiter auslassseitiger Flansch (22) an einem Ende des zweiten Strukturelements (20) gebildet ist, und der Rand des Reflektors (12) fest zwischen den ersten und zweiten Flansch (10, 22) geklemmt ist.

3. Reaktor zum Erzeugen von Feuchtigkeit nach Anspruch 1 oder 2, wobei das erste Strukturelement (4) und das zweite Strukturelement (20) jeweils ein Strukturrohr umfassen, und der Reflektor (12) eine Reflexionsplatte umfasst.

4. Reaktor zum Erzeugen von Feuchtigkeit nach Anspruch 1, 2 oder 3, wobei eine Katalysatorschicht (21) auf einer Oberfläche des Reflektors (12) gebildet ist, die der Reaktionskammer (18) und/oder einer inneren Oberfläche der Düsenöffnung (24) zugewandt ist.

5. Reaktor zum Erzeugen von Feuchtigkeit nach einem der vorhergehenden Ansprüche, wobei die Katalysatorschicht (21) einen Beschichtungsfilm (21b) umfasst, der auf einen Sperrfilm (21a) laminiert und fixiert ist.

6. Reaktor zum Erzeugen von Feuchtigkeit nach Anspruch 5, wobei der Beschichtungsfilm (21b) Platin umfasst, und der Sperrfilm (21a) eine der Substanzen TiN, TiC, TiCN, TiAlN, Al₂O₃, Cr₂O₃, SiO₂,CrN umfasst.

7. Reaktor zum Erzeugen von Feuchtigkeit nach Anspruch 2 oder 3, wobei der Rand des Reflektors (12) mittels eines mit einem Schraubgewinde versehenen Mutterelements (34), das auf der Außenumfangsfläche des ersten oder zweiten Strukturelements (4, 20) vorgesehen ist, und eines entsprechend mit einem Schraubgewinde versehenen Kopplungselements (32), das auf der Außenumfangsfläche des anderen Strukturelements (20, 4) vorgesehen ist, fest zwischen den ersten und zweiten Flansch (10, 22) geklemmt ist, wobei das Mutterelement dazu geeignet ist, in das Kopplungselement zu greifen.

8. Reaktor zum Erzeugen von Feuchtigkeit nach Anspruch 7, wobei ein Lager (36) zwischen dem Mutterelement (34) und einer Rückseite des Flansches (10, 22) angeordnet ist, auf der die Mutter vorgesehen ist, wodurch das Drehen der Kopplung (32) und der Mutter (34) vereinfacht ist.

## Revendications

1. Un réacteur (2) pour générer de l'humidité comprenant :
un premier élément de structure de réacteur côté entrée (4) et un deuxième élément de structure de réacteur côté sortie (20), lesquels premier et deuxième éléments de structure (4, 20) sont adaptés pour être assemblés afin de définir un espace intérieur ;
un orifice d'alimentation de gaz de matière première (6a) dans ledit premier élément de structure , lequel orifice d'alimentation de gaz est adapté pour alimenter en gaz de matière première un côté d'entrée (8) dudit espace intérieur ;
un passage d'alimentation de gaz humide (28) dans ledit deuxième élément de structure , adapté pour évacuer le gaz généré vers un orifice de prélèvement de gaz humide (30a) ; un réflecteur (12) encastré de façon étanche à l'air entre les premier et deuxième éléments de structure de réacteur (4, 20), lequel réflecteur définit une pluralité de trous de soufflage (16) à des emplacements prédéterminés en communication avec ledit espace intérieur du côté d'entrée (8) ;
une chambre de réacteur (18) comprenant un espace étroit entre ledit réflecteur (12) et ledit deuxième élément de structure de réacteur (20) ;
un orifice de buse (24) formé dans le deuxième élément de structure de réacteur (20) de sorte que ladite chambre de réacteur communique avec ledit passage d'alimentation de gaz humide (28) dans le deuxième élément de structure de réacteur ;
et une couche de revêtement de catalyseur (21) formée sur une surface de paroi de ladite chambre de réacteur en vis-à-vis du réflecteur, dans lequel lorsque de l'hydrogène et de l'oxygène amenés à partir de l'orifice d'alimentation de gaz de matière première s'écoulent dans la chambre de réaction au travers des trous de soufflage dans le réacteur, l'hydrogène et l'oxygène réagissent et génèrent un gaz humide dans un état de non combustion par effet catalytique de la couche de revêtement de catalyseur.

2. Un réacteur pour générer de l'humidité selon la revendication 1, dans lequel un premier rebord du côté d'entrée (10) est formé sur une extrémité du premier élément de structure (4) et un deuxième rebord du côté de sortie (22) est formé sur une extrémité du deuxième élément de structure (20) et la périphérie du réflecteur (12) est étroitement encastrée entre les premier et deuxième rebords (10, 22).

3. Un réacteur pour générer de l'humidité selon la revendication 1 ou la revendication 2, dans lequel le premier élément de structure (4) et le deuxième élément de structure (20) comportent chacun un tube structurel et ledit réflecteur (12) comprend une plaque de réflexion.

4. Un réacteur pour générer de l'humidité selon la revendication 1, la revendication 2 ou la revendication 3, dans lequel une couche de revêtement de catalyseur (21) est formée sur une surface du réflecteur (12) en vis-à-vis de ladite chambre de réaction (18) et/ou une surface intérieure de l'orifice de buse (24).

5. Un réacteur pour générer de l'humidité selon l'une quelconque des revendications précédentes, dans lequel ladite couche de revêtement de catalyseur (21) comprend un film revêtement (21b) stratifié et fixé sur un film barrière (21a).

6. Un réacteur pour générer de l'humidité selon la revendication 5, dans lequel ledit film revêtement (21b) comprend du platine et ledit film barrière (21a) comprend l'un quelconque des éléments TiN, TiC, TiCN, TiALN, Al₂O₃, Cr₂O₃, SiO₂, CrN.

7. Un réacteur pour générer de l'humidité selon la revendication 2 ou la revendication 3, dans lequel la périphérie du réflecteur (12) est étroitement encastrée entre les premier et deuxième rebords (10, 22) au moyen d'un élément à écrou fileté (34) prévu sur la surface périphérique extérieure de l'un des premier et deuxième éléments de structure (4, 20) et d'un élément de couplage fileté correspondant (32) prévu sur la surface périphérique extérieure de l'autre élément de structure (20, 4), dans lequel ledit élément d'écrou est adapté pour venir s'engager avec ledit élément de couplage.

8. Un réacteur pour générer de l'humidité selon la revendication 7, dans lequel un palier (36) est interposé entre ledit élément d'écrou (34) et un côté inverse du rebord (10, 22) sur lequel ledit écrou est disposé, afin de faciliter la rotation du couplage (32) et de l'écrou (34).
